# FASCICULE DE BREVET EUROPEEN

(11) **EP 2 395 543 B1**
(45) Date de publication et mention de la délivrance du brevet: **16.01.2013**
(21) Numéro de dépôt: 11167959.3
(22) Date de dépôt: 27.05.2011
(51) Int. Cl.: H01L 21/033, H01L 21/3213, G03F 7/033

(54) **Procédé de réalisation d'une grille de lignes conductrices d'accès croisées.**
Herstellungsverfahren eines Gitters aus überkreuzten Zugangsleiterbahnen
Method for manufacturing a grid of conductive lines with crossed access

(30) Priorité: 09.06.2010 FR 1054547
(43) Date de publication de la demande: 14.12.2011
(73) Titulaire: Commissariat à l'Énergie Atomique et aux Énergies Alternatives, 75015 Paris (FR); CENTRE NATIONAL DE LA RECHERCHE SCIENTIFIQUE, 75794 Paris Cedex (FR); Universite Joseph Fourier, 38140 Grenoble (FR)
(72) Inventeur: Buckley, Julien, 38000 Grenoble (FR); Aissou, Karim, 33170 Gradignan (FR); Baron, Thierry, 38120 Saint Egrève (FR); Molas, Gabriel, 38000 Grenoble (FR)
(74) Mandataire: Lebkiri, Alexandre

(56) Documents cités:
- WO-A1-2009/094282
- US-A1- 2007 161 237
- BLACK C T ET AL: "Polymer self assembly in semiconductor microelectronics", ELECTRON DEVICES MEETING, 2006. IEDM '06. INTERNATIONAL, IEEE, PI, 1 décembre 2006 (2006-12-01), pages 1-4, XP031078219, DOI: DOI:10.1109/IEDM.2006.346806 ISBN: 978-1-4244-0438-4
- CEROFOLINI G F ET AL: "A hybrid micro-nano-molecular route for nonvolatile memories", SEMICONDUCTOR SCIENCE AND TECHNOLOGY, IOP PUBLISHING LTD, GB, vol. 21, no. 9, 1 septembre 2006 (2006-09-01), pages 1315-1325, XP020098433, ISSN: 0268-1242, DOI: DOI:10.1088/0268-1242/21/9/017
- WU W ET AL: "One-kilobit cross-bar molecular memory circuits at 30-nm half-pitch fabricated by nanoimprint lithography", APPLIED PHYSICS A; MATERIALS SCIENCE & PROCESSING, SPRINGER, BERLIN, DE, vol. 80, no. 6, 1 mars 2005 (2005-03-01), pages 1173-1178, XP019336714, ISSN: 1432-0630, DOI: DOI:10.1007/S00339-004-3176-Y
- NAUENHEIM C ET AL: "Nano-Crossbar Arrays for Nonvolatile Resistive RAM (RRAM) Applications", 20080818, 18 août 2008 (2008-08-18), pages 464-467, XP031315526, ISBN: 978-1-4244-2103-9
- CHEN YONG ET AL: "Nanoscale molecular-switch devices fabricated by imprint lithography", APPLIED PHYSICS LETTERS, AIP, AMERICAN INSTITUTE OF PHYSICS, MELVILLE, NY, US, vol. 82, no. 10, 10 mars 2003 (2003-03-10) , pages 1610-1612, XP012033495, ISSN: 0003-6951, DOI: DOI:10.1063/1.1559439
- MYOUNG-JAE LEE ET AL: "2-stack 1D-1R Cross-point Structure with Oxide Diodes as Switch Elements for High Density Resistance RAM Applications", ELECTRON DEVICES MEETING, 2007. IEDM 2007. IEEE INTERNATIONAL, IEEE, PISCATAWAY, NJ, USA, 10 décembre 2007 (2007-12-10), pages 771-774, XP031389808, ISBN: 978-1-4244-1507-6

## Description

L'invention porte sur un procédé de réalisation d'une grille de lignes conductrices ou semi-conductrices d'accès croisées. L'invention trouve une application particulièrement intéressante dans le domaine de la réalisation de grille de lignes d'accès croisées pour dispositif mémoire, et plus spécifiquement pour des dispositifs à mémoire non volatile.

On connait différents procédés permettant de réaliser ce type de grille de lignes d'accès croisées.

Ainsi, le procédé dénommé S*n*PT ou « multi-spacer patterning technique » décrit dans le document « A hybrid micro-nano-molecular route for nonvolatile memories » (G F Cerofolini and D Mascolo, Semicond. Sci. Technol. 21 (2006) 1315-1325) » permet de réaliser un premier ensemble de lignes conductrices croisant un second ensemble de lignes conductrices. Ce procédé consiste à réaliser successivement, pour chaque ligne conductrice, un dépôt conforme sur un substrat et une gravure anisotropique.

L'inconvénient majeur de ce procédé réside dans le fait qu'il nécessite autant d'étapes de dépôt et de gravure que de lignes fabriquées. Or certaines applications (typiquement les architectures mémoires) nécessitent la réalisation d'un nombre très élevé de lignes entraînant un nombre d'étapes de dépôt et de gravure élevé induisant un coût et un temps de fabrication importants.

On connaît également un procédé de réalisation de grille de lignes conductrices d'accès croisées utilisant une technique de lithographie appelée "nanoimprint" ; ce procédé est décrit dans le document « One-kilobit cross-bar molecular memory circuits at 30-nm half-pitch fabricated by nanoimprint lithography » (Wu et al., Appl. Phys. A 80.1173-1178 (2005)). Sa mise en oeuvre nécessite l'emploi d'un moule transparent comportant des structures gravées (ou cavités) sur une de ses faces. Une résine est déposée sur un substrat. Une faible pression est ensuite exercée par le moule sur la résine de sorte que cette dernière emplisse les cavités du moule. La résine est ensuite photopolymérisée par émission d'un rayonnement UV au travers du moule transparent.

Ce procédé présente également certains inconvénients.

Un premier inconvénient réside dans le fait que les imperfections formées par la rugosité des flancs des cavités sont transmises aux flancs des motifs de la résine.

En outre, la différence entre la position théorique d'une cavité et sa position réelle sur le moule engendre des erreurs qui sont répétées lors de l'alignement de plusieurs niveaux.

Enfin, l'emploi du moule impose l'utilisation de deux couches de résine : une couche inférieure pour réaliser une étape de lift-off et une couche supérieure imprimée par le moule. Du fait du contact mécanique du moule avec la couche supérieure, on assiste à une détérioration prématurée de la surface du moule due aux frottements.

Un autre procédé décrit dans le document US2007161237 permet de réaliser une structure de lignes d'accès croisées en nanotubes de carbone ; ce procédé consiste à définir des zones sur un substrat par gravure chimique puis à réaliser un dépôt en phase vapeur de nanotubes sur ces zones. Lors du dépôt en phase vapeur, les nanotubes sont orientés par application d'un champ électrique.

En revanche, un tel procédé ne permet pas de positionner précisément les nanotubes. De ce fait, une telle structure à lignes d'accès croisées présente habituellement des nanotubes qui ne sont pas parfaitement parallèles entre eux et dont l'espacement est approximatif.

En outre, cette technique n'a été décrite qu'avec des nanotubes de carbone ou des nanofils de silicium réalisés par dépôt chimique en phase vapeur (CVD).

Un autre procédé de réalisation d'une grille à lignes d'accès croisées décrit dans le document « Nano-Crossbar Arrays for Nonvolatile Resistive RAM (RRAM) Applications », (C. Nauenheim et al., 8th IEEE Conference on Nanotechnology, 2008, pp. 464-467) utilise une lithographie à faisceau d'électrons combinée avec un procédé de type lift-off pour définir des lignes métalliques espacées de 100nm.

Outre le coût très élevé de la technique de lithographie par faisceau d'électrons, ce procédé nécessite un temps important d'exposition au faisceau d'électrons.

De façon connu, le procédé dénommé SNAP ou « Superlattice Nanowire Pattern Transfer » décrit dans le document « Applied physics letters, volume 82, number 10, pp. 1610-1612, 2003 » permet d'obtenir des lignes d'accès croisées en réalisant des lignes métalliques ou semi-conductrices parallèles entre elles. La technique est basée sur la conversion du contrôle en épaisseur de croissance de films minces vers celui du diamètre et de l'espacement, de lignes parallèles, réduits respectivement jusqu'à 8nm et 16nm.

Un tel procédé présente néanmoins des inconvénients. En effet, ce procédé permet de réaliser un nombre limité de lignes conductrices ou semi-conductrices et ne permet donc pas de couvrir la totalité de la surface d'un substrat en une seule étape. Ainsi, dès lors que l'on souhaite réaliser un grand nombre de lignes conductrices ou semi-conductrices, le coût de fabrication devient prohibitif.

On connaît également des procédés de réalisation de grille de lignes conductrices ou semi-conductrices d'accès croisées utilisant une technique de photolithographie de type UV. Un tel procédé est décrit dans le document « 2-stack 1D-1R Cross-point Structure with Oxide Diodes as Switch Elements for High Density Resistance RAM Applications », (Myoung-Jae Lee et al., proceedings of IEDM 2008, pp.771-774).

Ce type de procédé présente également des difficultés dans la mesure où la largeur et l'espacement des lignes conductrices ou semi-condudrices sont limités par le procédé de photolithographie de type UV.

Le document WO2009/094282 décrit un procédé de réalisation de deux niveaux de lignes utilisant des copolymères diblocs.

L'invention a donc plus particulièrement pour but de remédier aux inconvénients des procédés de l'art antérieur. Dans ce contexte, l'invention vise à proposer un procédé de réalisation d'une grille de lignes conductrices ou semi-conductrices d'accès croisées dont le nombre d'étapes est indépendant du nombre de lignes, le positionnement des lignes conductrices ou semi-conductrices étant maîtrisé et précis.

A cette fin, l'invention porte sur un procédé de réalisation d'une grille de lignes conductrices ou semi-conductrices d'accès croisées sur un substrat, la grille comportant :
- sur un isolant de grille, dans un plan parallèle au substrat, un premier niveau de lignes comportant une pluralité de premières lignes parallèles entre elles réalisées dans un matériau conducteur ou semi-conducteur ;
- au dessus du premier niveau de lignes, un deuxième niveau de lignes comportant une pluralité de deuxièmes lignes parallèles entre elles réalisées dans un matériau conducteur ou semi-conducteur, les deuxièmes lignes étant sensiblement perpendiculaires aux premières lignes,
ledit procédé **étant caractérisé en ce qu**'il comporte les étapes suivantes :
- former, sur le substrat, une première cavité de forme sensiblement rectangulaire ;
- former une deuxième cavité de forme sensiblement rectangulaire superposée à la première cavité, les première et deuxième cavités se croisant perpendiculairement de façon à former une cavité résultante ;
- recouvrir le fond de la cavité résultante d'une couche d'un premier copolymère dibloc comportant un réseau de lignes formé par une alternance de lignes d'un premier polymère et de lignes d'un deuxième polymère, les lignes étant agencées parallèlement suivant la longueur de la deuxième cavité ;
- retirer les lignes de premier polymère de façon à former une alternance de premières saignées et de lignes de deuxième polymère ;
- réaliser un dépôt conforme d'une couche d'un premier matériau conducteur ou semi-conducteur sur les saignées et les lignes de deuxième polymère ;
- retirer les lignes de deuxième polymère recouvertes du premier matériau conducteur ou semi-conducteur de façon à réaliser le premier niveau de lignes ;
- retirer sélectivement le matériau formant la deuxième cavité de façon à rendre accessible le fond de la première cavité recouvert partiellement suivant sa largeur du premier niveau de lignes ;
- déposer dans la première cavité rendue accessible, une couche d'un deuxième matériau conducteur ou semi-conducteur ;
- recouvrir la couche de deuxième matériau conducteur ou semi-conducteur, d'une couche d'un deuxième copolymère dibloc comportant un réseau de lignes formé par une alternance de lignes d'un troisième polymère et de lignes d'un quatrième polymère, les lignes étant sensiblement perpendiculaires aux premières lignes et deuxième lignes de polymères ;
- retirer les lignes de quatrième polymère de façon à former une alternance de deuxièmes saignées et de lignes de troisième polymère ;
- retirer dans les deuxièmes saignées le deuxième matériau conducteur ou semi-conducteur de façon à réaliser le deuxième niveau de lignes.

Il convient de noter que le premier et le deuxième polymères du premier copolymère dibloc sont de nature chimique différente. De même, le troisième polymère et le quatrième polymères du deuxième copolymère dibloc sont de nature chimique différente. En revanche, le premier copolymère et le deuxième copolymère peuvent être de nature chimique identique.

Grâce à l'invention, le nombre d'étapes du procédé ne dépend plus du nombre de lignes conductrices ou semi-conductrices réalisées. En effet, les premières lignes conductrices ou semi-conductrices sont réalisées simultanément au sein de la cavité résultante et les deuxièmes lignes conductrices ou semi-conductrices sont réalisées simultanément au sein de la première cavité. En d'autres termes, quel que soit le nombre de lignes conductrices ou semi-conductrices réalisées, le nombre d'étapes de fabrication est inchangé.

On notera que le procédé selon l'invention se différencie fondamentalement des procédés connus utilisant des copolymères diblocs pour définir des motifs en ligne et graver des canaux semiconducteurs. Un tel procédé est par exemple décrit dans le document « Polymer self assembly in semiconducteur microelectronics », (C.T. Black et al. IEE IEDM 2006). Ce procédé nécessite une surface adaptée pour recevoir le copolymère dibloc ainsi qu'une cavité rectangulaire dont la largeur correspond à un nombre déterminé de lignes de polymère et ne permet pas de réaliser un deuxième niveau de lignes avec la mise en oeuvre du même procédé. En effet, pour déposer un copolymère dibloc, il est nécessaire que la surface le recevant soit adaptée. Or, le premier niveau de lignes présente une topographie ne permettant pas de recevoir un copolymère dibloc. Par ailleurs, il est nécessaire d'utiliser une cavité rectangulaire dont la direction de la longueur est parallèle à celle des lignes de polymères et dont la largeur correspond à un nombre déterminé de lignes de polymères. A l'inverse, le procédé selon l'invention utilise avantageusement un agencement particulier d'une première cavité et d'une deuxième cavité permettant d'obtenir une cavité résultante, le matériau de la deuxième cavité pouvant être gravé sélectivement par rapport aux autres matériaux de la structure. Cette cavité résultante permet de réaliser un premier niveau de lignes. Puis, lorsque la deuxième cavité est supprimée, l'accès à la première cavité offre la possibilité de réaliser un deuxième niveau de lignes. Les dimensions de ces deux cavités permettent en outre d'obtenir le nombre recherché de lignes sur les deux niveaux.

De surcroît, grâce à la précision géométrique des réseaux de lignes des copolymères diblocs, on obtient des lignes dont l'espacement est parfaitement contrôlé et dont la précision surfacique est accrue.

Outre les caractéristiques principales qui viennent d'êtres mentionnées dans le paragraphe précédent, le procédé de l'invention peut présenter une ou plusieurs caractéristiques supplémentaires ci-dessous, considérées individuellement ou selon toutes les combinaisons techniquement réalisables :
- le procédé comporte, avant le dépôt dans la première cavité rendue accessible d'une couche d'un deuxième matériau conducteur ou semi-conducteur, une étape de dépôt d'une couche d'un matériau comportant des propriétés de commutation d'impédance par application d'un champ électrique, l'étape de retrait dans les deuxièmes saignées du deuxième matériau conducteur ou semi-conducteur s'accompagnant du retrait de la couche de matériau comportant des propriétés de commutation ;
- le matériau comportant des propriétés de commutation d'impédance par application d'un champ électrique est du type :
   - oxyde binaire ;
   - électrolyte solide ;
   - pérovskite à base d'oxyde ternaire ;
   - matériau à changement de phase ;
   - molécules ou polymères à caractéristiques de commutation de résistance ; ou
   - matériau magnétique pouvant former une jonction tunnel de type magnétique ou vanne de spin ;
- la première cavité comporte une largeur égale à un multiple du pas du deuxième copolymère dibloc ;
- la deuxième cavité comporte une largeur égale à un multiple du pas du premier copolymère dibloc ; de façon générale, le « pas » du premier copolymère est déterminé par la largeur (ou le diamètre) d'une ligne (ou d'une chaîne) du premier polymère additionnée à la largeur (ou le diamètre) d'une ligne (ou d'une chaîne) du deuxième polymère. De même, le « pas » du deuxième copolymère est déterminé par la largeur (ou le diamètre) d'une ligne (ou d'une chaîne) du troisième polymère additionnée à la largeur (ou le diamètre) d'une ligne (ou d'une chaîne) du quatrième polymère ;
- l'étape de formation de la première cavité est suivie des deux étapes suivantes :
   - déposer une couche de matériau isolant sur les bords et le fond de la première cavité ;
   - déposer, sur la couche du matériau isolant, une couche d'un matériau apte à être gravé de façon sélective par rapport aux lignes de deuxième polymère et au matériau isolant ;
- l'étape de formation de la deuxième cavité consiste à :
   - déposer une couche d'un matériau apte à être gravé de façon sélective par rapport aux matériaux formant le fond et les bords de la première cavité ;
   - retirer une partie de la couche de matériau de sorte que le fond de la deuxième cavité soit formé par le fond de la première cavité recouverte du matériau de la couche du matériau apte à être gravé de façon sélective par rapport aux lignes de deuxième polymère et au matériau isolant ;
- l'étape de retrait des lignes de premier polymère est suivie d'une étape de retrait, au travers des premières saignées, du matériau apte à être gravé de façon sélective par rapport aux lignes de deuxième polymère et à la couche de matériau isolant ;
- la ou les étapes de recouvrement par un copolymère dibloc sont réalisées par les étapes suivantes :
   - déposer la couche de copolymère dibloc ;
   - séparer les phases du copolymère dibloc déposé de façon à réaliser une alternance de lignes de deux polymères différents ;
- chaque étape de recouvrement par un copolymère dibloc est suivie d'une étape de structuration de sorte que le premier copolymère dibloc soit confiné dans la cavité résultante et/ou le deuxième copolymère dibloc soit confiné dans la première cavité ;
- un film de neutralisation est déposé préalablement au dépôt du premier et/ou du deuxième copolymère dibloc ;
- l'étape de dépôt du deuxième matériau conducteur ou semi-conducteur est suivie d'une étape de modification chimique de la couche de deuxième matériau conducteur ou semi-conducteur de façon à obtenir des terminaisons ayant une affinité chimique pour une des phases du deuxième copolymère dibloc ;
- l'un des premier ou deuxième polymères du premier copolymère dibloc présente une composition volumique comprise entre 0, 35 et 0, 65 ;
- l'un des troisième ou quatrième polymères du deuxième copolymère dibloc présente une composition volumique comprise entre 0, 35 et 0,65.

D'autres caractéristiques et avantages de l'invention ressortiront clairement de la description qui est donnée ci-après, à titre purement indicatif et nullement limitatif, de modes de réalisation faisant références à différentes figures sur lesquelles :
- les figures 1 à 20 illustrent les différentes étapes d'un procédé de réalisation d'une grille de lignes conductrices ou semi-conductrices d'accès croisées conforme à l'invention ;
- la figure 21 représente de façon schématique une grille de lignes conductrices ou semi-conductrices d'accès croisées obtenue directement par la mise en oeuvre du procédé conforme à l'invention.

Pour des raisons de clarté, seuls les éléments utiles pour la compréhension de l'invention ont été représentés, et ceci sans respect de l'échelle et de manière schématique. En outre, les éléments apparaissant sur différentes figures comportent les mêmes numéros.

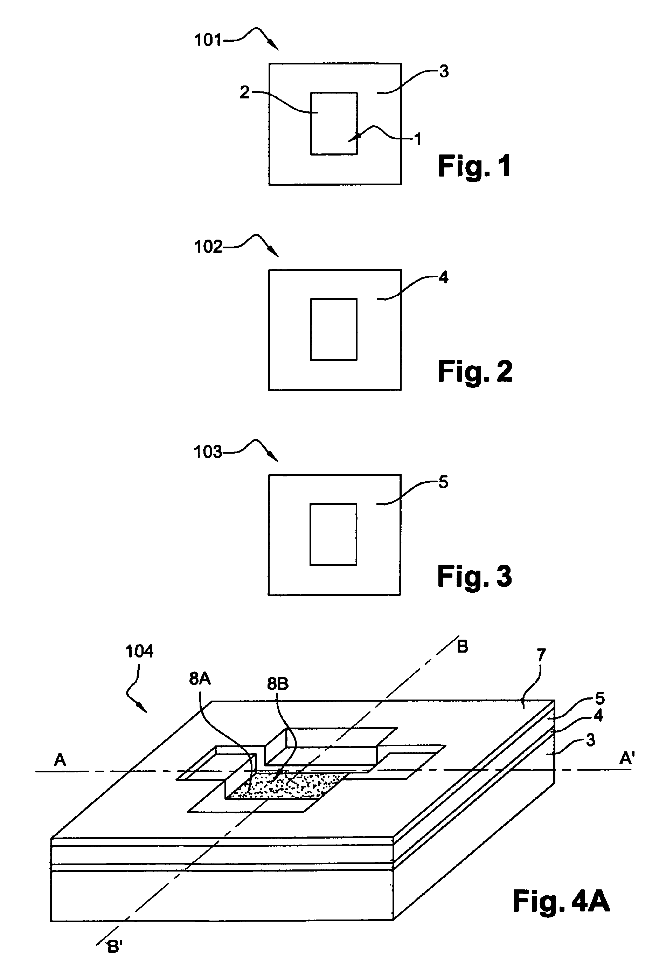

Les différentes étapes d'un procédé conforme à l'invention sont à présent décrites à l'appui des figures 1 à 20.

Plus précisément, la réalisation du premier niveau de lignes conductrices ou semi-conductrices est illustrée aux figures 1 à 11.

Le procédé selon l'invention comporte une première étape 101 (figure 1) consistant à former une première cavité 1, de forme rectangulaire, sur un substrat 2, par exemple en silicium. Pour réaliser cette première cavité 1, un dépôt d'une couche d'oxyde de silicium 3, d'épaisseur 50 nm est réalisé sur le substrat 2.

Puis, de façon à former la première cavité 1, une photolithographie de la couche d'oxyde de silicium 3 est réalisée. Ainsi, le fond et les bords de la première cavité 1 sont respectivement formés par le substrat 2 et la couche d'oxyde de silicium 3.

De façon générale et non limitative, le dépôt réalisé au cours de la première étape 101 ainsi que les dépôts réalisés au cours des étapes suivantes peuvent être réalisés par des procédés, connus et maîtrisés par l'homme du métier, tels que le dépôt chimique en phase vapeur (CVD), le dépôt par pulvérisation cathodique, le dépôt par canon à électrons ou encore le dépôt par évaporation thermique.

Par ailleurs, il convient de souligner que la largeur 11 de la première cavité 1 est déterminée de façon à être compatible avec un nombre de lignes formées par un premier polymère et un deuxième polymère d'une couche d'un premier copolymère dibloc qui sera déposée dans une étape ultérieure.

Pour la suite de la description, chaque longueur d'un élément « x » est référencée par la désignation Lx et chaque largeur d'un élément « x » est référencée par la désignation Ix.

Une deuxième étape 102 (figure 2) du procédé selon l'invention consiste à réaliser un dépôt, sur le fond et sur les bords de la première cavité 1, d'une couche d'un matériau isolant 4 en matériau diélectrique, tel que par exemple un nitrure de silicium.

Une troisième étape 103 (figure 3) du procédé selon l'invention consiste à déposer, sur la couche du matériau isolant 4, une couche d'un matériau 5 en oxyde de silicium. Ce dernier comporte préférentiellement des terminaisons de type ―OH, possédant une affinité chimique pour une des phases du copolymère qui y sera déposé ultérieurement.

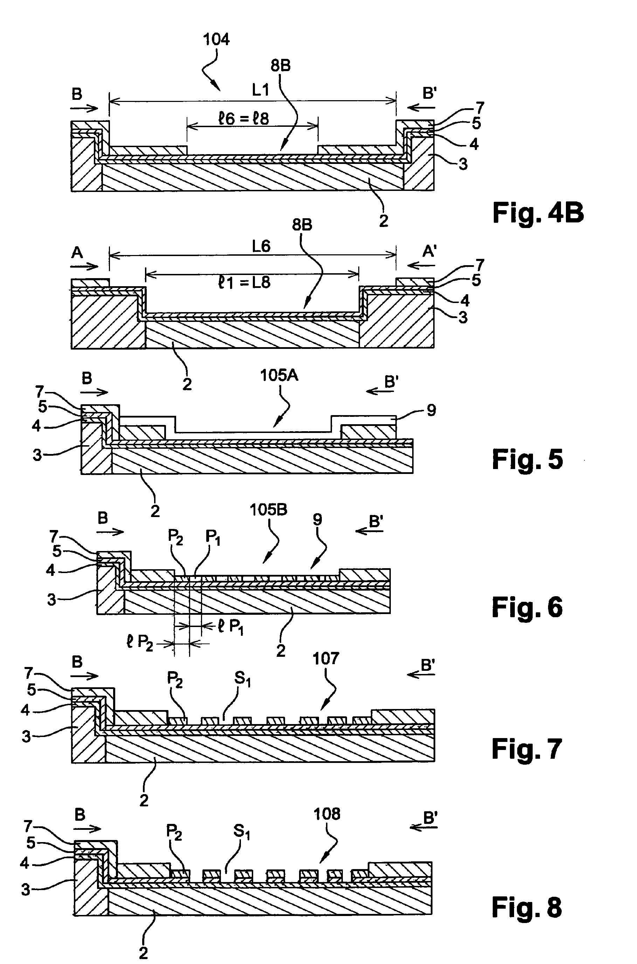

Une quatrième étape 104 (figures 4A, 4B) consiste à former une deuxième cavité 6 de forme sensiblement rectangulaire et superposée à la première cavité 1. Les première et deuxième cavités 1, 6 sont de surcroît disposées de façon sensiblement perpendiculaire (i.e. la direction de la largeur de l'une est perpendiculaire à la direction de la longueur de l'autre).

Pour ce faire, sur toute la surface de la couche de matériau 5 en oxyde de silicium précitée, est déposée une couche d'un matériau 7 en nitrure de silicium. Une gravure est ensuite réalisée dans cette dernière de façon à former la deuxième cavité 6. A titre d'exemple, on peut citer l'utilisation d'une méthode de gravure dite gravure sèche telle qu'une gravure de type plasma sous O₂ ou une méthode de gravure dite par voie humide de type H₃PO₄.

Il convient de noter que le fond de la deuxième cavité 6 est formé par la couche du matériau 5 en oxyde de silicium formant également le fond et les bords de la première cavité 1. On pourra donc noter que le matériau 7 en nitrure de silicium est choisi de façon à pouvoir être gravé de façon sélective par rapport au matériau 5 en oxyde de silicium.

Il convient également de noter que cette deuxième cavité 6 est superposée à la première cavité 1 et le croisement, de la première cavité 1 avec la deuxième cavité 6 forme une cavité résultante 8B dont le fond est formé par une surface d'intersection 8A (illustrée en pointillé sur la figure 4A).

Telle qu'illustrée sur la figure 4B, la cavité résultante 8B comporte une longueur L8 formée par la largeur I1 de la première cavité 1 et une largeur 18 formée par la largeur I6 de la deuxième cavité 6.

De surcroît, la largeur I6 de la deuxième cavité 6 est déterminée de façon à être compatible avec un nombre de lignes formées par un troisième polymère et un quatrième polymère d'une couche d'un deuxième copolymère dibloc qui sera déposée dans une étape ultérieure.

Une cinquième étape du procédé selon l'invention consiste à recouvrir le fond de la cavité résultante 8B d'une couche d'un premier copolymère dibloc 9 comportant un réseau de lignes formé par une alternance de lignes d'un premier polymère P1 et de lignes d'un deuxième polymère P2. Les lignes P1, P2 sont agencées parallèlement suivant la longueur L6 de la deuxième cavité 6. L'épaisseur de cette couche de premier copolymère dibloc 9 est préférentiellement inférieure à la profondeur de la première cavité 1.

Pour ce faire, l'étape de recouvrement peut être réalisée par les deux étapes successives suivantes :
- déposer, selon l'étape 105A (figure 5), sur le fond de la cavité résultante 8B, la couche du premier copolymère dibloc 9 comportant deux polymères de nature chimique différente et disposés aléatoirement ;
- séparer, selon l'étape 105B (figure 6), les phases du premier copolymère dibloc 9 de façon à réaliser un réseau de lignes formé par une alternance de lignes de premier polymère P1 et de lignes de deuxième polymère P2. Cette séparation de phases peut par exemple être réalisée au moyen d'un film de neutralisation.

En effet, pour obtenir une structure perpendiculaire, c'est-à-dire une orientation des chaînes des premier et deuxième polymères P1, P2 qui soit parallèle au substrat 2, il est nécessaire que les interactions entre la surface en contact (en l'espèce, la couche de matériau 5 en oxyde de silicium) et les différents polymères P1 et P2 soient différentes. Comme, la surface en contact n'est pas adaptée, l'obtention d'une structure perpendiculaire est alors obtenue en neutralisant la surface en contact. La neutralisation d'une surface est classiquement obtenue au moyen d'un film de neutralisation (non représenté) qui peut être un film en matériau polymère comportant des chaînes de polymères disposées aléatoirement.

Comme la couche de matériau 5 est en oxyde de silicium, un film de neutralisation en matériau polymère comprenant des chaînes de copolymère en polyméthacrylate de méthyle et de polystyrène disposées de façon aléatoires peut être utilisé. Un exemple de réalisation est décrit par « Mansky et al. dans Controlling Polymer-Surface Interactions with Random Copolymer Brushes » Science 275, 1458, 1997 ».

Lorsque la composition du copolymère est relativement symétrique les morphologies sont dites « lamellaires » ou dites « cylindre couchés ». De telles structures ont notamment été décrites dans l'article de Park et al « Directed Assembly of Lamallae-Forming Block Copolymers by Using Chemically and Topographically Patterned Substrates » Advanced Materials, 2007, 19, 607-611.

En outre, un copolymère avec une structure perpendiculaire au substrat dite lamellaire est classiquement obtenu lorsque la composition volumique des chaînes de polymères est adaptée. A ce titre, la composition volumique de l'un des premier ou deuxième polymères P1, P2 est de préférence comprise entre 0, 35 et 0, 65.

Selon une variante du procédé conforme à l'invention, l'étape de recouvrement peut être réalisée par un dépôt, sur le fond de la cavité résultante 8B, de la couche de premier copolymère dibloc 9 comportant un réseau de lignes pré-organisées formé par une alternance de lignes de premier polymère P1 et de lignes de deuxième polymère P2. Un tel copolymère peut être obtenu par une méthode de recuit thermique.

De façon générale, les lignes de premier et de deuxième polymères P1, P2 sont agencées parallèlement suivant la longueur L6 de la deuxième cavité 6.

Par ailleurs, l'épaisseur de la couche de matériau isolant 4, déposée au cours de la deuxième étape 102, peut être de l'ordre de la largeur d'une ligne de premier polymère P1 additionnée à la largeur d'une ligne de deuxième polymère P2, par exemple environ 10 nm.

Une sixième étape 105B (figure 6) permet ensuite de structurer le premier copolymère dibloc 9 dans la cavité résultante 8B. De façon à positionner strictement le premier copolymère dibloc 9 au sein de la cavité résultante 8B, on supprime l'excédent de la couche du premier copolymère dibloc 9 qui est disposé à l'extérieur de la cavité résultante 8B. Une telle action peut être réalisée, par exemple, au moyen de procédés de type photolithographie et gravure ou polissage mécano-chimique.

Par ailleurs, il convient de noter que la largeur 16 de la deuxième cavité 6 est choisie de telle sorte qu'elle soit égale à un multiple du pas du premier copolymère dibloc 9, le pas du premier copolymère dibloc 9 étant formé par la largeur (ou diamètre) IP1 d'une ligne (ou d'une chaîne) de premier polymère P1 additionnée à la largeur (ou diamètre) IP2 d'une ligne (ou d'une chaîne) de deuxième polymère P2. Cette particularité permet d'éviter de contraindre la couche du premier copolymère dibloc 9 au sein de la deuxième cavité 6 et par conséquent au sein de la cavité résultante 8B.

L'alternance des lignes de premier et de deuxième polymères P1, P2 se termine, de préférence, aux deux extrémités de la cavité résultante 8B par une ligne de même polymère (dans notre exemple le deuxième polymère P2).

En outre, le pas du réseau d'un copolymère est contrôlé par la longueur des chaînes de polymère, tout en conservant le critère relatif à la composition de chacun des polymères.

Au cours d'une septième étape 107 (figure 7), on retire une des phases de la couche du premier copolymère dibloc 9 de façon à former, une alternance de premières saignées S1 et de lignes de deuxième polymère P2. La couche de matériau 5 en oxyde de silicium déposée au cours de la troisième étape 103 est alors libre à l'emplacement des premières saignées S1. Si un film de neutralisation est utilisé, il est également éliminé au sein de ces premières saignées.

L'élimination est réalisée par toute technique adaptée. A titre d'exemple, si le premier polymère P1 est du polyméthacrylate de méthyle, il est possible de l'éliminer sélectivement par rapport au deuxième polymère P2 au moyen d'une insolation sous rayonnement ultraviolet profond.

Une huitième étape 108 (figure 8) du procédé selon l'invention consiste à retirer, par exemple par gravure SiO₂ plasma CF4 , ladite couche de matériau 5 en oxyde de silicium formant le fond des premières saignées S1. Il s'ensuit que le fond de ces dernières est formé par la couche de matériau isolant 4. Ceci est permis grâce à la particularité du matériau 5 qui est choisi de façon à pouvoir être gravé sélectivement. Plus particulièrement, ce dernier est choisi de façon à pourvoir être gravé de façon sélective par rapport au deuxième polymère P2 et au matériau isolant 4.

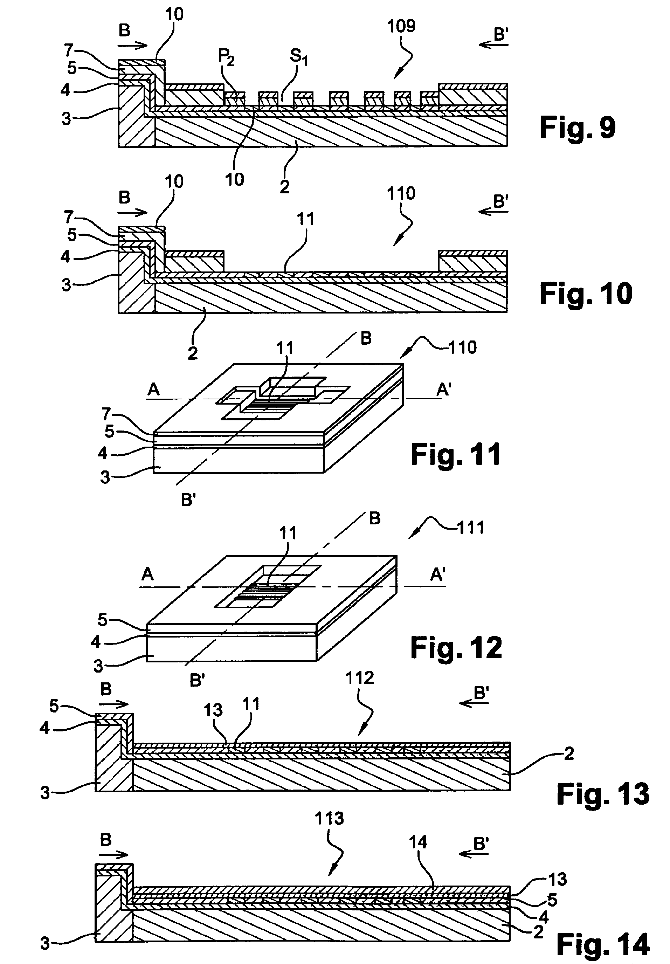

Une neuvième étape 109 (figure 9) du procédé consiste à réaliser un dépôt conforme d'une couche d'un premier matériau conducteur ou semi-conducteur 10, possédant une épaisseur sensiblement identique à celle de la couche de matériau 5 en oxyde de silicium, au fond des premières saignées S1 et au sommet des lignes de deuxième polymère P2.

De préférence, le premier matériau conducteur ou semi-conducteur 10 est du silicium amorphe, du silicium poly-cristallin ou tout autre matériau ayant des propriétés métalliques ou semi-conductrices. Ce matériau est déposé de manière à remplir au moins partiellement les premières saignées S1 et former ainsi des premières lignes conductrices ou semi-conductrices 11 à l'emplacement des lignes du premier polymère P1 éliminé.

Une dixième étape 110 (figure 10 et figure 11) consiste à retirer, par exemple par gravure, les lignes de deuxième polymère P2. A cette fin, on peut réaliser une photolithographie de type lift-off permettant de supprimer les lignes de deuxième polymère P2 et la couche du premier matériau conducteur ou semi-conducteur 10 située au sommet des lignes de deuxième polymère P2. On obtient ainsi une pluralité de premières lignes conductrices ou semi-conductrices 11 contenues au sein de la cavité résultante 8B. Ces premières lignes 11 sont disposées sur la couche de matériau isolant 4. Plus particulièrement, on obtient une pluralité de premières lignes conductrices ou semi-conductrices 11 parallèles à la longueur L6 de la deuxième cavité 6 ou encore à la longueur L8 de la cavité résultante 8B.

Une onzième étape 111 (figure 12) du procédé consiste à réaliser une gravure de type sélective par exemple avec une chimie à base de H₃PO₄, de façon à graver la couche du matériau 7 formant la deuxième cavité 6. Selon une telle mise en oeuvre, la couche de matériau 7 déposée au cours de la quatrième étape 104 est éliminée. Dans notre exemple, le matériau 7 a été choisi de façon à pouvoir être gravé sélectivement par rapport au matériau 5 en oxyde de silicium et au premier matériau conducteur ou semi-conducteur 10.

A l'issu de ces onze premières étapes, un premier niveau de lignes conductrices ou semi-conductrices est réalisé. La réalisation du deuxième niveau de ligne est à présent décrite à l'appui des figures 13 à 20.

Une douzième étape 112 (figure 13) du procédé consiste à déposer une couche d'un matériau 13 au-dessus des premières lignes conductrices 11 situées au sein de la première cavité 1. Le matériau de la couche 13 possède des propriétés de commutation d'impédance par application d'un champ électrique. De façon non limitative, le matériau de cette couche de matériau 13 peut appartenir à l'une des familles suivantes :
- oxyde binaire: tel que WO3, If2O3, ZrO2, RhO2 (voir US Patent 4839700), ou TiO, CuO, NiO, ZrO et HfO. Ces oxydes peuvent être obtenus par oxydation d'un métal, dépôt physique en phase vapeur ou encore par copulvérisation ;
- électrolyte solide : cellule mémoire à pont conducteur comprenant une électrode soluble (Ag, Cu...) en contact avec un matériau jouant le rôle d'électrolyte solide (GeSe, oxyde SiO2...)
- pérovskite. Ce dernier est un matériau à base d'oxyde ternaire de type PCMO, SrTiO3, SrZrO3 et BaTiO3 ;
- matériaux à changement de phase comme par exemple les verres de chalcogénure (GeSbTe) ;
- molécules, polymères comme par exemple des films minces moléculaires ou polymères à caractéristiques de commutation de résistance ;
- matériau magnétique pouvant former une jonction tunnel de type magnétique ou vanne de spin.

Une treizième étape 113 (figure 14) du procédé consiste à déposer une couche d'un deuxième matériau conducteur ou semi-conducteur 14 sur la couche de matériau 13 déposée au cours de la douzième étape 112.

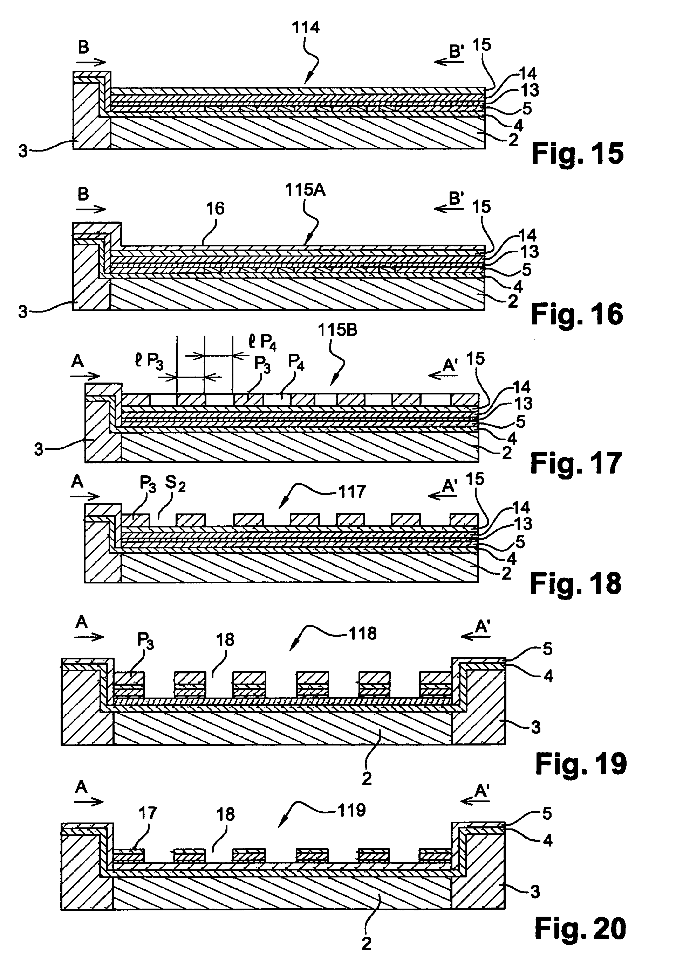

Une quatorzième étape 114 (figure 15) consiste à réaliser une modification chimique de la surface de la couche du deuxième matériau conducteur ou semi-conducteur 14 afin d'y augmenter le nombre de terminaisons -OH. Cette particularité permet d'augmenter l'affinité avec la couche de deuxième copolymère 16 qui est déposée au cours de la quinzième étape suivante. Le nombre de terminaisons -OH peut être augmenté en déposant, sur la couche du deuxième matériau conducteur ou semi-conducteur 14, une couche d'un matériau 15 de type HfO₂ dont la surface libre est riche en terminaison -OH. Ce matériau peut être déposé par ALD (pour Atomic Layer Deposition en anglais).

Comme indiqué précédemment, une quinzième étape du procédé selon l'invention consiste à recouvrir la couche de matériau 15 ou plus généralement la surface de la couche du deuxième matériau conducteur ou semi-conducteur 14 ayant été modifiée chimiquement d'une couche d'un deuxième copolymère dibloc 16 comportant un réseau de lignes formé par une alternance de lignes d'un troisième polymère P3 et de lignes d'un quatrième polymère P4.

Pour ce faire, l'étape de recouvrement peut être réalisée par les deux étapes successives suivantes :
- déposer selon l'étape 115A (figure 16), sur la couche de matériau 15, la couche du deuxième copolymère dibloc 16, la couche du deuxième copolymère dibloc 16 comportant deux polymères de natures chimiques différentes et disposés aléatoirement ;
- séparer selon l'étape 115B (figure 17) les phases du deuxième copolymère dibloc 16 de façon à réaliser un réseau de lignes formé par une alternance de lignes de troisième polymère P3 et de lignes de quatrième polymère P4. Les techniques d'obtention d'un tel réseau ont été présentées lors de l'étape 105B et sont transposables à cette étape 115B.

Selon une variante du procédé conforme à l'invention, l'étape de recouvrement de la couche de matériau 15 peut être réalisée par un dépôt du deuxième copolymère dibloc 16 comportant un réseau de lignes pré-organisées formé par une alternance de lignes de troisième polymère P3 et de lignes de quatrième polymère P4.

De façon générale, les lignes de troisième et de quatrième polymères P3, P4 sont agencées parallèlement suivant la longueur L1 de la première cavité 1. Par ailleurs, il convient de noter que la largeur 11 de la première cavité 1 est choisie de telle sorte qu'elle soit égale à un multiple du pas du deuxième copolymère dibloc 16, le pas du deuxième copolymère dibloc 16 étant formé par la largeur (ou diamètre) IP3 d'une ligne (ou d'une chaîne) de troisième polymère P3 additionnée à la largeur (ou diamètre) IP4 d'une ligne (ou d'une chaîne) de quatrième polymère P4. Cette particularité permet d'éviter de contraindre la couche du deuxième copolymère dibloc 16 au sein de la première cavité 1.

L'alternance des lignes de troisième et de quatrième polymères P3, P4 se termine, de préférence, aux deux extrémités de la première cavité 1 par une ligne de même polymère (dans notre exemple le troisième polymère P3).

En outre, les lignes de troisième polymère P3 et de quatrième polymère P4 sont sensiblement perpendiculaires aux premières lignes conductrices ou semi-conductrices 11.

Une seizième étape 115B (figure 17) permet de structurer le deuxième copolymère dibloc 16 dans la première cavité 1. De manière conventionnelle, de façon à positionner strictement le deuxième copolymère dibloc 16 au sein de la première cavité 1, on supprime l'excédent de la couche du deuxième copolymère dibloc 16 qui est disposé à l'extérieur de la première cavité 1. Une telle action peut être réalisée, par exemple, au moyen de procédés de type photolithographie et gravure ou polissage mécano-chimique.

Une dix-septième étape 117 (figure 18) consiste à retirer, par exemple par photolithographie, une des phases (les lignes de quatrième polymère P4 dans notre exemple) de la couche de deuxième copolymère dibloc 16 de façon à former une alternance de deuxièmes saignées S2 et de lignes de troisième polymère P3.

Une dix-huitième étape 118 (figure 19) consiste à réaliser une gravure de l'empilement des couches au travers des deuxièmes saignées S2. Plus précisément, on grave :
- la couche de matériau 13 possédant des propriétés de commutation d'impédance par application d'un champ électrique ;
- la couche de matériau conducteur ou semi-conducteur 14 ;
- lorsqu'une telle couche est présente, la couche de matériau 16 dont la surface libre est riche en terminaison -OH.

Cette étape est réalisée dans le but d'obtenir une alternance de deuxièmes lignes conductrices ou semi-conductrices 17.

Si l'épaisseur de copolymère ne permet pas de graver tout l'empilement, on peut réaliser un lift métal ou Al₂O₃ et utiliser le métal ou l'Al₂O₃ comme masque : après dépôt du deuxième copolymère dibloc 16, on élimine une phase par rapport à l'autre, on dépose le métal ou l'Al₂O₃ par exemple par ALD (Atomic Layer Deposition) conforme, puis on réalise un lift-off par gravure plasma du métal ou de l'Al₂O₃ déposée sur la phase du copolymère n'ayant pas été éliminée ; les lignes d'Al₂O₃ ou de métal restantes sont utilisées comme masque de gravure de l'empilement.

Le procédé comporte de surcroît, une dix-neuvième étape 119 (figure 20) au cours de laquelle on retire les lignes de troisième polymère P3 de la couche de deuxième copolymère 16. Pour ce faire, il est possible de réaliser une gravure de type photolithographie.

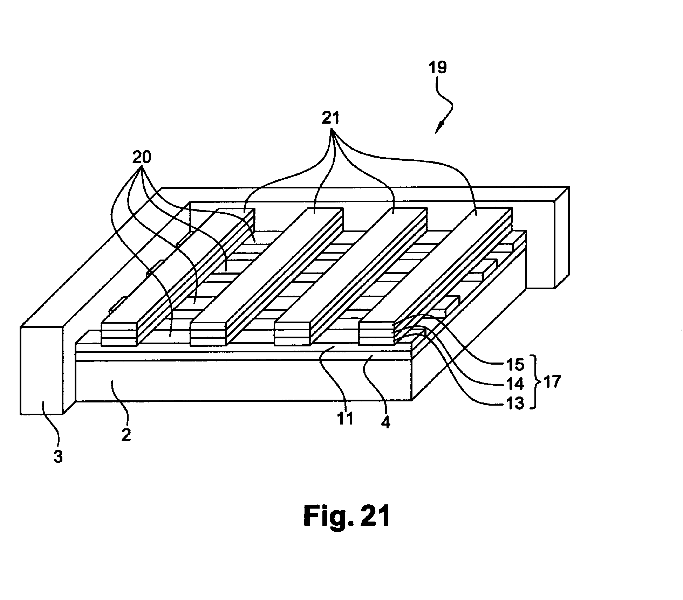

La structure finale d'une grille 19 directement obtenue par la mise en oeuvre du procédé de réalisation est illustrée sur la figure 21. Une telle grille 19 comporte un premier niveau 20 de lignes formé par les premières lignes conductrices ou semi-conductrices 11 et un deuxième niveau 21 de lignes formé par les deuxièmes lignes conductrices ou semi-conductrices 17. Plus précisément, la grille 19 comporte sur la couche de matériau isolant 4, dans un plan parallèle au substrat 2, un premier niveau 20 de lignes comportant une pluralité de premières lignes 11 réalisées dans le premier matériau conducteur ou semi-conducteur 10. En outre, sur le premier niveau 20 de lignes 11, se trouve un deuxième niveau 21 de lignes comportant une pluralité de deuxièmes lignes 17 réalisées dans le deuxième matériau conducteur ou semi-conducteur 14. Les deuxièmes lignes 17 sont sensiblement perpendiculaires aux premières lignes 11.

Les première et deuxième cavités 1, 6 réalisées respectivement au cours de la première étape 101 et de la quatrième étape 104 sont réalisées à des dimensions micrométriques.

En outre, les premier et deuxième copolymères diblocs 9, 16 peuvent, par exemple, comporter chacun un polymère de type polyméthacrylate de méthyle et un polymère de type polystyrène.

De façon non limitative, le pas des premier et deuxième copolymères 9, 16 peut être de l'ordre de 20 nm.

Par ailleurs, la couche d'oxyde de silicium 3 déposée au cours de la première étape 101 de formation de la première cavité 1 présente une épaisseur de 50 nm ou plus de façon à être supérieure ou égale à la somme des épaisseurs de la couche 13 possédant des propriétés de commutation d'impédance par application d'un champ électrique, la couche du deuxième matériau conducteur ou semi-conducteur 14, la couche d'un matériau 15 dont la surface libre est riche en terminaison -OH et la couche du deuxième copolymère dibloc 16,

Grâce au procédé de l'invention, le coût et le temps de réalisation d'une grille 19 obtenue par la mise en oeuvre du procédé de l'invention n'est pas dépendant du nombre de lignes conductrices ou semi-conductrices réalisées.

En outre, le procédé de l'invention permet notamment :
- de réaliser des lignes conductrices ou semi-conductrices sur la quasi-totalité de la surface d'un substrat ;
- d'espacer avec précision des lignes conductrices ou semi-conductrices d'une distance déterminée.

L'invention est décrite dans ce qui précède à titre d'exemple, il est entendu que l'homme du métier est à même de réaliser différentes variantes du procédé de réalisation d'une grille de lignes conductrices ou semi-conductrices d'accès croisées, en particulier concernant les technologies de gravures et de dépôts utilisées sans pour autant sortir du cadre du brevet.

## Revendications

1. Procédé de réalisation d'une grille (19) de lignes conductrices ou semi-conductrices d'accès croisées sur un substrat (2), la grille (19) comportant :
- sur un isolant (4) de grille, dans un plan parallèle au substrat (2), un premier niveau (20) de lignes (11) comportant une pluralité de premières lignes (11) parallèles entre elles réalisées dans un matériau conducteur ou semi-conducteur ;
- au dessus du premier niveau (20) de lignes (11), un deuxième niveau (21) de lignes (17) comportant une pluralité de deuxièmes lignes (17) parallèles entre elles réalisées dans un matériau conducteur ou semi-conducteur, les deuxièmes lignes (17) étant sensiblement perpendiculaires aux premières lignes (11),
ledit procédé étant **caractérisé en ce qu'**il comporte les étapes suivantes :
- former (101), sur le substrat (2), une première cavité (1) de forme sensiblement rectangulaire ;
- former (104) une deuxième cavité (6) de forme sensiblement rectangulaire superposée à la première cavité (1), les première et deuxième cavités (1, 6) se croisant perpendiculairement de façon à former une cavité résultante (88) ;
- recouvrir le fond de la cavité résultante (8B) d'une couche d'un premier copolymère dibloc (9) comportant un réseau de lignes formé par une alternance de lignes d'un premier polymère (P1) et de lignes d'un deuxième polymère (P2), les lignes étant agencées parallèlement suivant la longueur (L6) de la deuxième-cavité (6) ;
- retirer (107) les lignes de premier polymère (P1) de façon à former une alternance de premières saignées (S1) et de lignes de deuxième polymère (P2) ;
- réaliser un dépôt conforme (109) d'une couche d'un premier matériau conducteur ou semi-conducteur (10) sur les saignées (S1) et les lignes de deuxième polymère (P2) ;
- retirer (110) les lignes de deuxième polymère (P2) recouvertes du premier matériau conducteur ou semi-conducteur (10) de façon à réaliser le premier niveau (20) de lignes (11) ;
- retirer (111) sélectivement le matériau formant la deuxième cavité (6) de façon à rendre accessible le fond de la première cavité (1) recouvert partiellement suivant sa largeur (11) du premier niveau (20) de lignes (11) ;
- déposer (113) dans la première cavité (1) rendue accessible, une couche d'un deuxième matériau conducteur ou semi-conducteur (14) ;
- recouvrir la couche de deuxième matériau conducteur ou semi-conducteur (14), d'une couche d'un deuxième copolymère dibloc (16) comportant un réseau de lignes formé par une alternance de lignes d'un troisième polymère (P3) et de lignes d'un quatrième polymère (P4), les lignes (P3, P4) étant sensiblement perpendiculaires aux premières lignes et deuxième lignes de polymères (P1, P2) ;
- retirer (117) les lignes de quatrième polymère (P4) de façon à former une alternance de deuxièmes saignées (S2) et de lignes de troisième polymère (P3) ;
- retirer (118) dans les deuxièmes saignées (S2) le deuxième matériau conducteur ou semi-conducteur (14) de façon à réaliser le deuxième niveau (21) de lignes (17).

2. Procédé selon la revendication précédente **caractérisé en ce qu'**il comporte, avant le dépôt (113) dans la première cavité (1) rendue accessible d'une couche d'un deuxième matériau conducteur ou semi-conducteur (14), une étape de dépôt (112) d'une couche d'un matériau (13) comportant des propriétés de commutation d'impédance par application d'un champ électrique, l'étape de retrait (118) dans les deuxièmes saignées (S2) du deuxième matériau conducteur ou semi-conducteur (14) s'accompagnant du retrait de la couche de matériau (13) comportant des propriétés de commutation.

3. Procédé selon la revendication précédente **caractérisé en ce que** le matériau (13) comportant des propriétés de commutation d'impédance par application d'un champ électrique est du type :
- oxyde binaire ;
- électrolyte solide ;
- pérovskite à base d'oxyde ternaire ;
- matériau à changement de phase ;
- molécules ou polymères à caractéristiques de commutation de résistance ; ou
- matériau magnétique pouvant former une jonction tunnel de type magnétique ou vanne de spin.

4. Procédé selon l'une des revendications précédentes **caractérise en ce que** :
- la première cavité (1) comporte une largeur (11) égale à un multiple du pas du deuxième copolymère dibloc (16) ;
- la deuxième cavité (6) comporte une largeur (16) égale à un multiple du pas du premier copolymère dibloc (9).

5. Procédé selon l'une des revendications précédentes **caractérise en ce que** l'étape de formation (101) de la première cavité (1) est suivie des deux étapes suivantes :
- déposer (102) une couche de matériau isolant (4) sur les bords et le fond de la première cavité (1) ;
- déposer (103), sur la couche du matériau insolant (4), une couche d'un matériau (5) apte à être gravé de façon sélective par rapport aux lignes de deuxième polymère (P2) et au matériau isolant (4).

6. Procédé selon la revendication précédente **caractérisé en ce que** l'étape de formation (104) de la deuxième cavité consiste à :
- déposer une couche d'un matériau (7) apte à être gravé de façon sélective par rapport aux matériaux formant le fond et les bords de la première cavité (1) ;
- retirer une partie de la couche de matériau (7) de sorte que le fond de la deuxième cavité (6) soit formé par le fond de la première cavité (1) recouverte du matériau de la couche du matériau (5) apte à être gravé de façon sélective par rapport aux lignes de deuxième polymère (P2) et au matériau isolant (4).

7. Procédé selon l'une des revendications 5 ou 6 **caractérisé en ce que** ladite étape (107) de retrait des lignes de premier polymère (P1) est suivie d'une étape de retrait (108), au travers des premières saignées (S1), du matériau (5) apte à être gravé de façon sélective par rapport aux lignes de deuxième polymère (P2) et à la couche de matériau isolant (4).

8. Procédé selon l'une des revendications précédentes **caractérisé en ce que** la ou les étapes de recouvrement par un copolymère dibloc sont réalisées par les étapes suivantes :
- déposer (105A, 115A) la couche de copolymère dibloc (9, 16) ;
- séparer (105B, 115B) les phases du copolymère dibloc (9, 16) déposé de façon à réaliser une alternance de lignes de deux polymères différents (P1, P2, P3, P4).

9. Procédé selon l'une des revendications précédentes **caractérisé en ce que** chaque étape de recouvrement par un copolymère dibloc est suivie d'une étape de structuration (1058, 115B) de sorte que le premier copolymère dibloc (9) soit confiné dans la cavité résultante (8B) et/ou le deuxième copolymère dibloc (16) soit confiné dans la première cavité (1).

10. Procédé selon l'une des revendications précédentes **caractérisé en ce qu'**un film de neutralisation est déposé préalablement au dépôt du premier et/ou du deuxième copolymère dibloc (9, 16).

11. Procédé selon l'une des revendications précédentes **caractérisé en ce que** l'étape de dépôt (113) du deuxième matériau conducteur ou semi-conducteur (14) est suivie d'une étape de modification chimique (114) de la couche de deuxième matériau conducteur ou semai-conducteur (14) de façon à obtenir des terminaisons ayant une affinité chimique pour une des phases du deuxième copolymère dibloc (16).

12. Procédé selon l'une des revendications précédentes **caractérisé en ce que** :
- l'un des premier ou deuxième polymères (P1, P2) du premier copolymère dibloc (9) présente une composition volumique comprise entre 0, 35 et 0, 65 ;
- l'un des troisième ou quatrième polymères (P3, P4) du deuxième copolymère dibloc (16) présente une composition volumique comprise entre 0, 35 et 0, 65.

## Claims

1. A method for producing a crossbar array (19) of crossed conductive or semi-conductive access lines on a substrate (2), the crossbar array (19) comprising:
- on a crossbar array insulator (4), in a plane parallel to the substrate (2), a first level (20) of lines (11) comprising a plurality of first lines (11) parallel with one another produced in a conductive or semi-conductive material;
- above the first level (20) of lines (11), a second level (21) of lines (17) comprising a plurality of second lines (17) parallel with one another produced in a conductive or semi-conductive material, the second lines (17) being essentially perpendicular to the first lines (11),
said method being **characterised in that** it comprises the following steps:
- forming (101) on the substrate (2) a first cavity (1) of essentially rectangular shape;
- forming (104) a second cavity (6) of essentially rectangular shape, superimposed on the first cavity (1), the first and second cavities (1, 6) crossing one another perpendicularly so as to form a resultant cavity (8B);
- covering the base of the resultant cavity (8B) with a layer of a first diblock copolymer (9) comprising an array of lines formed by an alternation of lines of a first polymer (P1) and lines of a second polymer (P2), the lines being arranged in parallel following the length (L6) of the second cavity (6);
- removing (107) the lines of first polymer (P1) so as to form an alternation of first grooves (S1) and lines of second polymer (P2);
- producing a conformal deposit (109) of a layer of a first conductive or semi-conductive material (10) on the grooves (S1) and the lines of second polymer (P2);
- removing (110) the lines of the second polymer (P2) covered by the first conductive or semi-conductive material (10) in such a way as to produce the first layer (20) of lines (11);
- removing (111) selectively the material forming the second cavity (6) in such a way as to render accessible the base of the first cavity (1) partially covered over its width (11) by the first level (20) of lines (11);
- depositing (113), in the first cavity (1) rendered accessible, a layer of a second conductive or semi-conductive material (14);
- covering the layer of second conductive or semi-conductive material (14) with a layer of a second diblock copolymer (16) comprising an array of lines formed by an alternation of lines of a third polymer (P3) and lines of a fourth polymer (P4), the lines (P3, P4) being essentially perpendicular to the first lines and second lines of polymers (P1, P2);
- removing (117) the lines of fourth polymer (P4) in such a way as to form an alternation of second grooves (S2) and lines of third polymer (P3);
- removing (118), in the second grooves (S2), the second conductive or semi-conductive material (14) in such a way as to produce the second level (21) of lines (17).

2. The method according to the preceding claim, **characterised in that** it comprises, before the depositing (113), in the first cavity (1) rendered accessible, of a layer of a second conductive or semi-conductive material (14), a step for depositing (112) a layer of a material (13) having switching properties by the application of an electric field, the step for removing (118), in the second grooves (S2), the second conductive or semi-conductive material (14) being accompanied by the removal of the layer of material (13) having switching properties.

3. The method according to the preceding claim, **characterised in that** the material (13) having switching commutation properties by the application of an electric field is of the type:
- binary oxide;
- solid electrolyte;
- perovskite based on ternary oxide;
- phase-change material;
- molecules or polymers with resistance switching characteristics; or
- magnetic material capable of forming a tunnel junction of the magnetic type or a spin valve.

4. The method according to any one of the preceding claims, **characterised in that**:
- the first cavity (1) has a width (11) equal to a multiple of the pitch of the second diblock copolymer (16);
- the second cavity (1) has a width (16) equal to a multiple of the pitch of the first diblock copolymer (9).

5. The method according to any one of the preceding claims, **characterised in that** the step for forming (101) the first cavity (1) is followed by the following two steps:
- depositing (102) a layer of insulating material (4) on the edges and the base of the first cavity (1);
- depositing (103), on the layer of the insulating material (4), a layer of a material (5) suitable for being etched in a selective manner with respect to the lines of second polymer (P2) and the insulating material (4).

6. The method according to the preceding claim, **characterised in that** the step for forming (104) the second cavity consists in:
- depositing a layer of a material (7) suitable for being etched in a selective manner with respect to the materials forming the base and the edges of the first cavity (1) ;
- removing a part of the layer of material (7) such that the base of the second cavity (6) is formed by the base of the first cavity (1) covered by the material of the layer of the material (5) suitable for being etched in a selective manner with respect to the lines of second polymer (P2) and the insulating material (4).

7. The method according to any one of claims 5 or 6, **characterised in that** said step (107) for removing lines of first polymer (P1) is followed by a step for removing (108), through the first grooves (S1), the material (5) suitable for being etched in a selective manner with respect to the lines of second polymer (P2) and the layer of insulating material (4).

8. The method according to any one of the preceding claims, **characterised in that** the step or steps for covering by a diblock copolymer are carried out by the following steps:
- depositing (105A, 115A) the layer of diblock copolymer (9, 16);
- separating (105B, 115B) the phases of the deposited diblock copolymer (9, 16) so as to produce an alternation of lines of two different polymers (P1, P2, P3, P4).

9. The method according to any one of the preceding claims, **characterised in that** each step for covering by a diblock copolymer is followed by a structuring step (105B, 115B) such that the first diblock copolymer (9) is confined in the resultant cavity (8B) and/or the second diblock copolymer (16) is confined in the first cavity (1).

10. The method according to any one of the preceding claims, **characterised in that** a neutralisation film is deposited prior to the deposition of the first and/or the second diblock copolymer (9, 16).

11. The method according to any one of the preceding claims, **characterised in that** the step for depositing (113) the second conductive or semi-conductive material (14) is followed by a step for chemical modification (114) of the layer of second conductive or semi-conductive material (14) so as to obtain terminations having a chemical affinity for one of the phases of the second diblock copolymer (16).

12. The method according to any one of the preceding claims, **characterised in that**:
- one of the first or second polymers (P1, P2) of the first diblock copolymer (9) has a volumetric composition between 0.35 and 0.65;
- one of the third or fourth polymers (P3, P4) of the second diblock copolymer (16) has a volumetric composition between 0.35 and 0.65.

## Patentansprüche

1. Verfahren zum Ausführen eines Gitters (19) aus gekreuzten Leiter- oder Halbleiter-Anschlussleitungen auf einem Substrat (2), wobei das Gitter (19) Folgendes umfasst:
- auf einem Gitterisolator (4) in einer zum Substrat (2) parallelen Ebene, eine erste Ebene (20) von Leitungen (11), die mehrere untereinander parallele erste Leitungen (11) umfasst, die in einem Leiter- oder Halbleitermaterial ausgeführt werden;
- über der ersten Ebene (20) von Leitungen (11) eine zweite Ebene (21) von Leitungen (17), die mehrere untereinander parallele zweite Leitungen (17) umfasst, die in einem Leiter- oder Halbleitermaterial ausgeführt werden, wobei die zweiten Leitungen (17) im Wesentlichen senkrecht zu den ersten Leitungen (11) sind,
wobei das Verfahren **dadurch gekennzeichnet ist, dass** es die folgenden Schritte umfasst:
- Bilden (101) eines ersten Hohlraums (1) mit im Wesentlichen rechteckiger Form auf dem Substrat (2);
- Bilden (104) eines zweiten Hohlraums (6) mit im Wesentlichen rechteckiger Form, der den ersten Hohlraum (1) überlagert, wobei der erste und der zweite Hohlraum (1, 6) sich derart senkrecht kreuzen, dass ein daraus resultierender Hohlraum (8B) gebildet wird;
- Bedecken des Bodens des resultierenden Hohlraums (8B) mit einer Schicht aus einem ersten Diblockcopolymer (9) das ein Leitungsnetz umfasst, das durch einen Wechsel von Leitungen aus einem ersten Polymer (P1) und von Leitungen aus einem zweiten Polymer (P2) gebildet wird, wobei die Leitungen gemäß der Länge (L6) des zweiten Hohlraums (6) parallel angeordnet werden;
- Entfernen (107) der Leitungen aus dem ersten Polymer (P1), derart, dass ein Wechsel von ersten Schnittfugen (S1) und von Leitungen aus dem zweiten Polymer (P2) gebildet wird;
- Ausführen einer konformen Abscheidung (109) einer Schicht aus einem ersten Leiter- oder Halbleitermaterial (10) auf den Schnittfugen (S1) und den Leitungen aus dem zweiten Polymer (P2);
- Entfernen (110) der Leitungen aus dem zweiten Polymer (P2), die mit dem ersten Leiter- oder Halbleitermaterial (10) bedeckt sind, derart, dass die erste Ebene (20) von Leitungen (11) ausgeführt wird;
- selektives Entfernen (111) des Materials, das den zweiten Hohlraum (6) bildet, derart, dass der Boden des ersten Hohlraums (1), der gemäß seiner Breite (11) teilweise von der ersten Ebene (20) von Leitungen (11) bedeckt ist, zugänglich gemacht wird;
- Abscheiden (113) einer Schicht aus einem zweiten Leiter- oder Halbleitermaterial (14) im ersten Hohlraum (1), der zugänglich gemacht wurde;
- Bedecken der Schicht aus dem zweiten Leiter- oder Halbleitermaterial (14) mit einer Schicht aus einem zweiten Diblockcopolymer (16), die ein Leitungsnetz umfasst, das durch einen Wechsel von Leitungen aus einem dritten Polymer (P3) und von Leitungen aus einem vierten Polymer (P4) gebildet wird, wobei die Leitungen (P3, P4) im Wesentlichen senkrecht zu den ersten und zweiten Leitungen aus Polymeren (P1, P2) sind;
- Entfernen (117) der Leitungen aus dem vierten Polymer (P4), derart, dass ein Wechsel von zweiten Schnittfugen (S2) und von Leitungen aus dem dritten Polymer (P3) gebildet wird;
- Entfernen (118) des zweiten Leiter- oder Halbleitermaterials (14) in den zweiten Schnittfugen (S2), derart, dass die zweite Ebene (21) von Leitungen (17) ausgeführt wird.

2. Verfahren nach dem vorhergehenden Anspruch, **dadurch gekennzeichnet, dass** es vor der Abscheidung (113) einer Schicht aus einem zweiten Leiter- oder Halbleitermaterial (14) in dem ersten Hohlraum (1), der zugänglich gemacht wurde, einen Schritt der Abscheidung (112) einer Schicht aus einem Material (13) umfasst, das Impedanzumschalteigenschaften durch Anlegen eines elektrischen Feldes umfasst, wobei der Schritt des Entfernens (118) in den zweiten Schnittfugen (S2) des zweiten Leiter- oder Halbleitermaterials (14) vom Entfernen der Materialschicht (13) begleitet wird, die Umschalteigenschaften umfasst.

3. Verfahren nach dem vorhergehenden Anspruch, **dadurch gekennzeichnet, dass** das Material (13), das Impedanzumschalteigenschaften durch Anlegen eines elektrischen Feldes umfasst, vom folgenden Typ ist:
- binäres Oxid;
- Festelektrolyt;
- Perowskit auf Basis von ternärem Oxid;
- Phasenwechselmaterial;
- Moleküle oder Polymere mit Widerstandsumschalteigenschaften; oder
- magnetisches Material, das einen Tunnelübergang des magnetischen oder Spinventiltyps bilden kann.

4. Verfahren nach einem der vorhergehenden Ansprüche, **dadurch gekennzeichnet, dass**:
- der erste Hohlraum (1) eine Breite (11) aufweist, die gleich einem Vielfachen des Abstands des zweiten Diblockcopolymers (16) ist;
- der zweite Hohlraum (1) eine Breite (16) aufweist, die gleich einem Vielfachen des Abstands des ersten Diblockcopolymers (9) ist.

5. Verfahren nach einem der vorhergehenden Ansprüche, **dadurch gekennzeichnet, dass** dem Schritt der Bildung (101) des ersten Hohlraums (1) die zwei folgenden Schritte folgen:
- Abscheiden (102) einer Schicht aus Isoliermaterial (4) auf den Rändern und dem Boden des ersten Hohlraums (1);
- Abscheiden (103) einer Schicht aus einem Material (5), das geeignet ist, um auf selektive Weise in Bezug zu den Leitungen aus dem zweiten Polymer (P2) und dem Isoliermaterial (4) geätzt zu werden, auf der Schicht aus Isoliermaterial (4).

6. Verfahren nach dem vorhergehenden Anspruch, **dadurch gekennzeichnet, dass** der Schritt der Bildung (104) des zweiten Hohlraums aus Folgendem besteht:
- Abscheiden einer Schicht aus einem Material (7), das geeignet ist, um auf selektive Weise in Bezug auf das Material, das den Boden und die Ränder des ersten Hohlraums (1) bildet, geätzt zu werden;
- Entfernen eines Abschnitts der Schicht aus dem Material (7), derart, dass der Boden des zweiten Hohlraums (6) durch den Boden des ersten Hohlraums (1) gebildet wird, der mit dem Material der Schicht aus dem Material (5) bedeckt ist, das geeignet ist, um auf selektive Weise in Bezug zu den Leitungen aus dem zweiten Polymer (P2) und dem Isoliermaterial (4) geätzt zu werden.

7. Verfahren nach einem der Ansprüche 5 oder 6, **dadurch gekennzeichnet, dass** dem Schritt (107) der Entfernung der Leitungen aus dem ersten Polymer (P1) ein Schritt der Entfernung (108) des Materials (5), das geeignet ist, um auf selektive Weise in Bezug zu den Leitungen aus dem zweiten Polymer (P2) und zur Schicht aus Isoliermaterial (4) geätzt zu werden, durch erste Schnittfugen (S1) folgt.

8. Verfahren nach einem der vorhergehenden Ansprüche, **dadurch gekennzeichnet, dass** der oder die Schritte des Bedeckens mit einem Diblockcopolymer durch die folgenden Schritte ausgeführt wird/werden:
- Abscheiden (105A, 115A) der Diblockcopolymerschicht (9, 16);
- Trennen (105B, 115B) der Phasen des abgeschiedenen Diblockcopolymers (9, 16), derart, dass ein Wechsel von Leitungen aus zwei verschiedenen Polymeren (P1, P2, P3, P4) ausgeführt wird.

9. Verfahren nach einem der vorhergehenden Ansprüche, **dadurch gekennzeichnet, dass** jedem Schritt des Abdeckens mit einem Diblockcopolymer ein Strukturierungsschritt (105B, 115B) folgt, derart, dass das erste Diblockcopolymer (9) in dem resultierenden Hohlraum (8B) eingeschlossen wird und/oder das zweite Diblockcopolymer (16) in dem ersten Hohlraum (1) eingeschlossen wird.

10. Verfahren nach einem der vorhergehenden Ansprüche, **dadurch gekennzeichnet, dass** vor dem Abscheiden des ersten und/oder zweiten Diblockcopolymers (9, 16) eine dünne Neutralisationsschicht abgeschieden wird.

11. Verfahren nach einem der vorhergehenden Ansprüche, **dadurch gekennzeichnet, dass** dem Schritt des Abscheidens (113) des zweiten Leiter- oder Halbleitermaterials (14) ein Schritt der chemischen Veränderung (114) der Schicht aus dem zweiten Leiter- oder Halbleitermaterial (14) folgt, derart, dass Abschlüsse erhalten werden, die eine chemische Affinität für eine der Phasen des zweiten Diblockcopolymers (16) aufweisen.

12. Verfahren nach einem der vorhergehenden Ansprüche, **dadurch gekennzeichnet, dass**:
- eines des ersten oder zweiten Polymers (P1, P2) des ersten Diblockcopolymers (9) eine Volumenzusammensetzung aufweist, die zwischen 0,35 und 0,65 enthalten ist;
- eines des dritten oder vierten Polymers (P3, P4) des zweiten Diblockcopolymers (16) eine Volumenzusammensetzung aufweist, die zwischen 0,35 und 0,65 enthalten ist.
